# FASCICULE DE BREVET EUROPEEN

(11) **EP 0 367 345 B1**
(45) Date de publication et mention de la délivrance du brevet: **06.09.1995**
(21) Numéro de dépôt: 89202727.7
(22) Date de dépôt: 30.10.1989
(51) Int. Cl.: G01R 31/28, G06F 11/22, G01R 31/3177

(54) **Analyseur logique avec double déclenchement**
Logikanalysator mit Doppel-Triggerung
Logic analyser with double triggering

(30) Priorité: 04.11.1988 FR 8814423
(43) Date de publication de la demande: 09.05.1990
(73) Titulaire: LABORATOIRES D'ELECTRONIQUE PHILIPS, 94450 Limeil-Brévannes (FR); Philips Electronics N.V., 5621 BA Eindhoven (NL)
(72) Inventeur: Boutigny, Pierre-Henri c/o Société Civile S.P.I.D., F-75007 Paris (FR); Nguyen, Huy Anh c/o Sociöté Civile S.P.I.D., F-75007 Paris (FR); Raoulx, Denis Luc Alain c/o Société Civile S.P.I.D, F-75007 Paris (FR)
(74) Mandataire: Landousy, Christian

(56) Documents cités:
- EP-A- 0 258 956
- DE-C- 3 019 473
- ELECTRONIQUE INDUSTRIELLE
- COMPUTER DESIGN
- Electronique industrielle no. 112, 15 septembre 1986, pages 55-63, Paris, F.B.COMBY: " L'interet d'une acquisition en temporel transitionell en analyse logique radipe", page 59 paragraphe: " Une double analyse permet des mesures couplees", page 60; figure 11
- Computer design mars 1981, pages 119-126, P.Dittman et al.: Logic analyzers simplify system integration tasks, pages 121,122, figure 2C

## Description

L'invention concerne un analyseur logique comprenant :
- un sélectionneur de voies possédant des premières entrées pour recevoir une composition de signaux numériques, des secondes entrées pour recevoir à un instant donné une première combinaison de référence de signaux numériques, et des premières portes logiques pour détecter, selon un premier mode, que la première combinaison est reproduite sur les premières entrées,
- un compteur, commandé par une horloge validée par la sortie du sélectionneur, la sortie du sélectionneur démarrant également le compteur qui reçoit préalablement une première valeur de consigne définissant une première durée prédéterminée,
- un premier moyen de mémorisation qui mémorise et délivre un premier signal de validation actif lorsque la première combinaison reste reproduite au-delà de ladite première durée, le premier moyen de mémorisation étant activé par le compteur.

Une invention de ce genre est connue du document GB-A-2 060 182 qui décrit un analyseur logique muni d'un dispositif de reconnaissance de mots. Il comprend un certain nombre de voies d'entrée et un reconnaisseur de mots qui permet de détecter une combinaison de bits présente simultanément sur les voies d'entrée. Ce document concerne plus particulièrement une possibilité d'extension pour des combinaisons ayant un nombre de bits qui dépasse le nombre de voies d'entrée. Le préambule de la revendication 1 est basé sur le document GB-A-2 060 182.

Un tel analyseur logique possède une partie de déclenchement qui permet de sélectionner la partie utile du signal à mémoriser et de déclencher l'arrêt de l'acquisition des données quand un certain événement a lieu. Cette possibilité est dite à déclenchement vertical car l'événement recherché est la présence durant un certain laps de temps d'un mot de données prédéterminé. Ce déclenchement agit simultanément sur les N voies d'entrée.

Mais ce document ne permet pas de réaliser un autre type de déclenchement qui pourrait faciliter l'utilisation d'un analyseur logique qui est un déclenchement horizontal permettant de détecter des combinaisons caractéristiques d'un fonctionnement défectueux d'un appareillage à tester.

On connaît également un analyseur logique rapide décrit dans "Electronique Industrielle" n° 112, 15 septembre 1986, pages 55-63, Paris, par B. COMBY. Cet analyseur peut effectuer une acquisition des états logiques par une mesure unique de chaque état ou effectuer une acquisition temporelle des états logiques par une suite de mesures effectuées sur chaque état logique. Ce dernier cas nécessite un suréchantillonnage. Mais ceci ne concerne pas la recherche de combinaison d'états logiques préprogrammés.

Le but poursuivi est donc de réaliser un analyseur logique qui offre la possibilité d'utiliser soit le déclenchement vertical soit le déclenchement horizontal au choix de l'utilisateur. Le déclenchement horizontal doit agir sur une seule voie d'entrée et rechercher la présence de certaines séquences temporelles parmi le flot de données d'entrée. Pour réduire les coûts de fabrication il est de plus nécessaire que ceci soit obtenu avec un nombre réduit de composants.

Ce but est atteint avec un analyseur logique pour lequel :
- le sélectionneur possède des troisièmes entrées pour recevoir une seconde combinaison de référence et des secondes portes logiques pour sélectionner, selon un second mode, une voie des premières entrées sur laquelle est détectée une apparition d'une suite de bits identiques dans la composition de signaux numériques,
- le compteur reçoit préalablement une seconde valeur de consigne définissant une seconde durée prédéterminée, le compteur étant démarré par la sortie dudit sélectionneur,
- des seconds moyens de mémorisation détectent lorsque l'apparition de la suite de bits identiques sur la voie sélectionnée est inférieure à la seconde durée prédéterminée et mémorisent et délivrent dans ce cas un second signal de validation,
- le sélectionneur sélectionne, en entrée, le premier ou le second mode selon que la seconde combinaison de référence sélectionne respectivement toutes les voies ou une seule voie.
- un multiplexeur sélectionne en sortie l'un des signaux de validation à l'aide d'un signal de mode de déclenchement.

Pour effectuer la sélection des voies selon le déclenchement vertical ou horizontal, les premiers moyens pour détecter la première combinaison comprennent pour chaque voie une première-porte logique qui reçoit une voie de ladite composition et un des N bits de la première combinaison de référence, et les seconds moyens pour sélectionner une des voies comprennent pour chaque voie une seconde porte logique qui reçoit un des N bits de la seconde combinaison de référence, la sortie de la première porte logique étant réunie à l'entrée de la seconde porte logique, les secondes portes logiques affectées à chaque voie ayant leurs sorties réunies à une porte logique effectuant un ET logique entre toutes ces sorties pour délivrer le signal de sortie du sélectionneur.

Ainsi, selon le déclenchement vertical, toutes les voies programmées pourront être examinées simultanément pour détecter si la combinaison de référence est apparue pendant une durée prédéterminée. De même, selon le déclenchement horizontal, une seule voie pourra être sélectionnée et examinée sur certaines périodes de temps pour détecter si une suite de bits identiques est apparue pendant une durée inférieure à une durée prédéterminée. Pour le déclenchement vertical le sélecteur de voies effectue également la reconnaissance de mots. Sa sortie peut être mémorisée dans une bascule pour être délivrée au multiplexeur. Pour le déclenchement horizontal la reconnaissance de mots est effectuée par le compteur suivi de ses bascules.

L'invention sera mieux comprise à l'aide des figures suivantes données à titre d'exemples non limitatifs qui représentent :
figure 1 : un schéma électrique des moyens de détection d'une combinaison de signaux selon l'invention,
figure 2 : un exemple de schéma détaillé d'un sélectionneur de voies,
figures 3A, 3B : deux chronogrammes correspondant au schéma de la figure 1 pour les deux modes de fonctionnement.

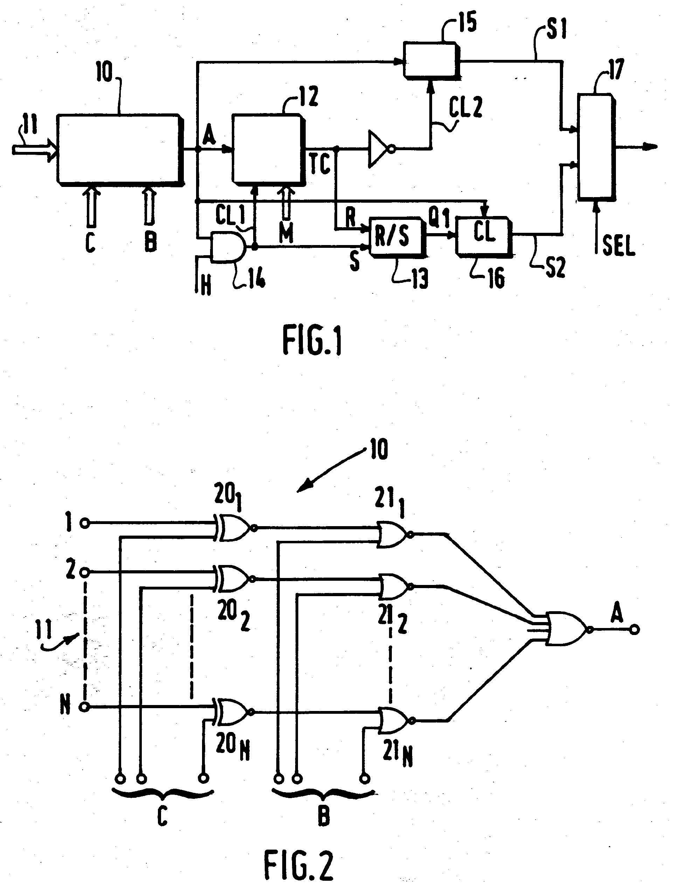

Sur la figure 1 est représenté le sélectionneur de voies 10 qui reçoit sur le bus d'entrée 11 les voies d'entrée de l'analyseur logique. Il reçoit une combinaison de bits C qui permet d'opérer la sélection des voies et la reconnaissance de mots selon le déclenchement vertical. Il reçoit également une combinaison de bits B qui permet de sélectionner une voie parmi toutes les entrées de l'analyseur logique.

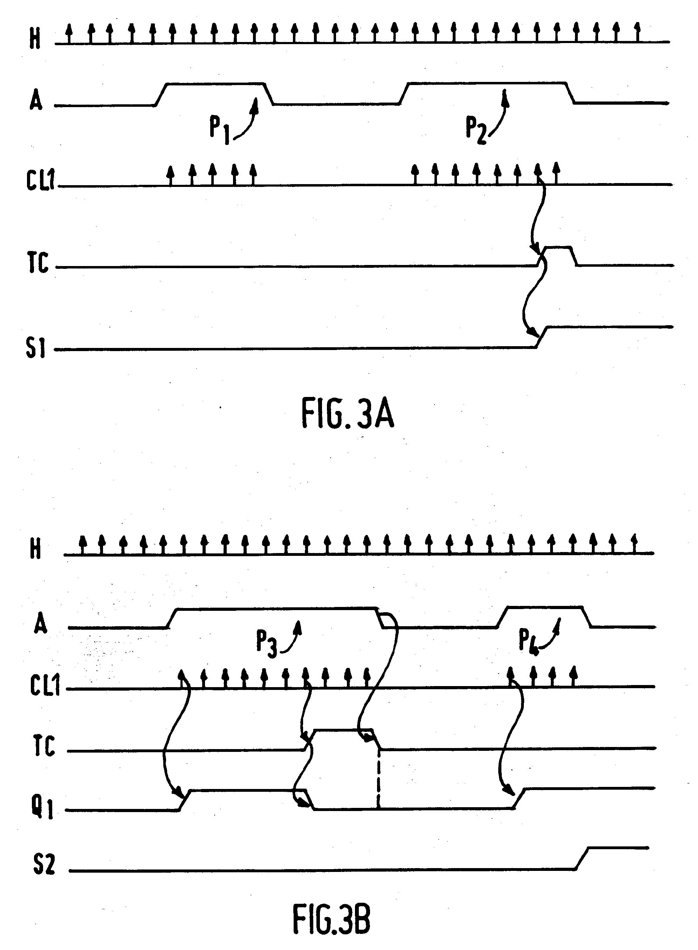

En déclenchement vertical lorsque la combinaison de référence est apparue simultanément sur les voies d'entrée, le signal au point A passe à un état logique déterminé par exemple l'état 1. Ce mode de fonctionnement est représenté sur la figure 3A. Lorsque le signal A passe à l'état 1 la porte ET 14 (figure 1) délivre un signal CL1 qui sert d'horloge à un compteur 12. Celui-ci est préalablement chargé avec une valeur de consigne M définissant la durée prédéterminée. Ainsi si par exemple M a été programmé pour une durée de sept coups d'horloge, le passage de A à l'état 0 avant une durée inférieure à sept coups d'horloge (cas P1) ne provoquera aucun changement de la sortie TC du compteur. Par contre lorsque le signal A reste à l'état logique 1 après une durée supérieure à sept coups d'horloge (cas P2) ceci entraîne le passage de la sortie TC à l'état logique 1 et la sortie S1 d'une bascule 15 recopie le signal A et passe à l'état logique 1 sur le front descendant de l'horloge CL2.

En déclenchement horizontal lorsqu'une voie est sélectionnée le signal présent sur cette voie apparaît au point A. Supposons que l'évènement à détecter fasse apparaître en A un signal à l'état logique 1 (figure 3B). Lorsque le signal en A a l'état logique 1, l'horloge CL1 passe à l'état logique 1 et déclenche le début de comptage du compteur 12 qui a préalablement été chargé avec la valeur de consigne M. Le signal CL1 actionne également une entrée d'une bascule R/S 13 et met sa sortie Q1 à l'état logique 1. Si le compteur atteint la valeur de consigne M (par exemple 7 coups d'horloge) avant que le signal A change d'état logique (cas P3) alors la sortie TC fait basculer la sortie Q1 de la bascule 13 de type R/S à l'état logique 0. Lorsque le front descendant du signal A apparaît, il valide dans la bascule 16 de type D le signal Q1 qui est copié selon S2 selon un état logique 0.

Lorsque le signal A passe de l'état logique 1 à l'état logique 0 avant que le compteur n'ait atteint la valeur de consigne M (cas P4), alors la sortie TC n'a pas basculé à l'état logique 1 et lorsque le front descendant de A se présente sur la bascule 16, la sortie Q1 qui est restée à l'état logique 1 est recopiée par la bascule 16 de type D sur sa sortie S2.

Ainsi le multiplexeur 17 peut sélectionner le mode vertical ou le mode horizontal à l'aide du signal SEL et délivrer le signal de déclenchement. Cette sélection est effectuée préférentiellement en programmant le passage du signal SEL afin de pouvoir observer successivement les deux modes de fonctionnement.

La figure 2 représente le sélectionneur 10 des voies 1, 2 ... N. Le bus d'entrée 11 arrive sur des portes logiques opérant la fonction OU exclusif inverse 20₁ ... 20_{N}. Ces portes reçoivent la combinaison de référence C. Leurs sorties sont réunies à des portes logiques 21₁, 21₂ ... 21_{N} opérant la fonction NON-OU. Ces portes reçoivent la combinaison de référence B. Leurs sorties sont réunies à une ou plusieurs portes logiques, dans l'exemple une porte NON-OU. En déclenchement vertical, la combinaison B valide toutes les portes 21₁ à 21_{N}. Lorsque la combinaison d'entrée est identique à la combinaison de référence C, la sortie A passe à l'état logique 1.

Il est évidemment possible à l'homme du métier d'opérer avec une logique inverse en modifiant le type de porte utilisé sans sortir du cadre de l'invention.

## Revendications

1. Analyseur logique comprenant :
- un sélectionneur (10) de voies possédant des premières entrées (11) pour recevoir une composition de signaux numériques, des secondes entrées pour recevoir à un instant donné une première combinaison (C) de référence de signaux numériques, et des premières portes logiques (20₁ - 20_{N}) pour détecter, selon un premier mode, que la première combinaison (C) est reproduite sur les premières entrées,
- un compteur (12), commandé par une horloge (CL1) validée par la sortie du sélectionneur (10), la sortie du sélectionneur démarrant également le compteur qui reçoit préalablement une première valeur de consigne (M) définissant une première durée prédéterminée,
- un premier moyen (15) de mémorisation qui mémorise et délivre un premier signal (S1) de validation actif lorsque la première combinaison (C) reste reproduite au-delà de ladite première durée, le premier moyen de mémorisation étant activé par le compteur (12), caractérisé en ce que :
- le sélectionneur (10) possède des troisièmes entrées pour recevoir une seconde combinaison (B) de référence et des secondes portes logiques (21₁ - 21_{N}) pour sélectionner, selon un second mode, une voie des premières entrées (11) sur laquelle est détectée une apparition d'une suite de bits identiques dans la composition de signaux numériques,
- le compteur (12) reçoit préalablement une seconde valeur de consigne (M) définissant une seconde durée prédéterminée, le compteur étant démarré par la sortie dudit sélectionneur (10),
- des seconds moyens (13, 16) de mémorisation détectent lorsque l'apparition de la suite de bits identiques sur la voie sélectionnée est inférieure à la seconde durée prédéterminée et mémorisent et délivrent dans ce cas un second signal (S2) de validation,
- le sélectionneur (10) sélectionne, en entrée, le premier ou le second mode selon que la seconde combinaison (B) de référence sélectionne respectivement toutes les voies ou une seule voie,
- un multiplexeur (17) sélectionne en sortie l'un des signaux (S1, S2) de validation à l'aide d'un signal (SEL) de mode de déclenchement.

2. Analyseur logique selon la revendication 1, caractérisé en ce que, pour opérer sur N voies, le sélectionneur (10) comprend affecté à chaque voie : une dite première porte logique qui reçoit une voie et un des N bits de la première combinaison (C) de référence, la sortie de cette première porte logique étant réunie à l'entrée d'une dite seconde porte logique qui reçoit également un des N bits de la seconde combinaison (B) de référence, la première combinaison (C) de référence étant destinée à sélectionner un mot binaire quelconque, la seconde combinaison (B) de référence étant destinée à sélectionner une des N voies ou toutes les N voies pour former la commande de voies, les secondes portes logiques affectées à chaque voie ayant leurs sorties réunies à une porte logique effectuant le ET logique de toutes ces sorties pour délivrer le signal de sortie (A) du sélectionneur (10).

3. Analyseur logique selon les revendications 1 ou 2, caractérisé en ce que le premier moyen de mémorisation est constitué d'une bascule (15) qui mémorise la sortie du sélectionneur (10).

4. Analyseur logique selon une des revendications 1 à 3, caractérisé en ce que les seconds moyens de mémorisation sont constitués d'une bascule (13) de type R/S suivie d'une bascule (16) de type D.

## Patentansprüche

1. Logikanalysator mit:
- einem Kanal-Wähler (10) mit ersten Eingängen (11) zum Empfang einer Zusammensetzung digitaler Signale, mit zweiten Eingängen zum Empfangen einer ersten Bezugskombination (C) digitaler Signale zu einem gegebenen Zeitpunkt und mit ersten Logikgattern (20₁-20_{N}) zum Detektieren, entsprechend einer ersten Betriebsart, daß die erste Kombination (C) auf den ersten Eingängen reproduziert worden ist,
- einem Zähler (12), gesteuert von einem Takt (CL1), der von dem Ausgang des Wählers (10) freigegeben wird, wobei der Ausgang des Wählers auch den Zähler startet, der zuvor einen ersten Einstellwert (M) empfängt, der eine erste vorbestimmte Dauer definiert,
- einem ersten Speichermittel (15), das ein erstes Freigabesignal (S1) speichert und abgibt, das aktiv ist, wenn die erste Kombination (C) über die erste genannte Dauer hinaus reproduziert bleibt, wobei das erste Speichermittel von dem Zähler (12) aktiviert wird,
dadurch gekennzeichnet, daß
- der Wähler (10) dritte Eingänge hat zum Empfangen einer zweiten Bezugskombination (B) und zweite Logikgatter (21₁ - 21_{N}) zum Wählen, entsprechend einer zweiten Betriebsart, eines Kanals der ersten Eingänge (11), auf dem in der Zusammensetzung digitaler Signale ein Auftreten einer Folge identischer Bits detektiert worden ist,
- der Zähler (12) zuvor einen zweiten Einstellwert (M) empfängt, der eine zweite vorgegebene Dauer definiert, wobei der Zähler vom Ausgang des genannten Wählers (10) gestartet wird,
- zweite Speichermittel (13, 16) detektieren, wenn das Auftreten der Folge identischer Bits auf dem gewählten Kanal kürzer als die zweite vorbestimmte Dauer ist, und in diesem Fall ein zweites Freigabesignal (S2) speichern und abgeben,
- der Wähler (10) am Eingang die erste oder zweite Betriebsart wählt, je nachdem, ob die zweite Bezugskombination (B) alle Kanäle oder einen einzigen Kanal wählt,
- ein Multiplexer (17) am Ausgang eines der Freigabesignale (S1, S2) mit Hilfe eines Triggerungsartsignals (SEL) wählt.

2. Logikanalysator nach Anspruch 1, dadurch gekennzeichnet, daß der Wähler (10), um auf N Kanälen zu arbeiten, für jeden Kanal folgendes umfaßt: ein genanntes erstes Logikgatter, das einen Kanal und eines der N Bits der ersten Bezugskombination (C) empfängt, wobei der Ausgang dieses ersten Logikgatters mit dem Eingang eines zweiten Logikgatters verbunden ist, das ebenfalls eines der N Bits der zweiten Bezugskombination (B) empfängt, wobei die erste Bezugskombination (C) ein beliebiges Binärwort selektieren soll, die zweite Bezugskombination (B) einen der N Kanäle oder alle N Kanäle wählen soll, um die Kanalsteuerung zu bilden, wobei die Ausgänge der jedem Kanal zugeordneten zweiten Logikgatter mit einem Logikgatter verbunden sind, das für alle Ausgänge die logische UND-Verknüpfung ausführt, um das Ausgangssignal (A) des Wählers (10) zu liefern.

3. Logikanalysator nach Anspruch 1 oder 2, dadurch gekennzeichnet, daß das erste Speichermittel aus einem Flipflop (15) besteht, das die Ausgabe des Wählers (10) speichert.

4. Logikanalysator nach einem der Ansprüche 1 bis 3, dadurch gekennzeichnet, daß die zweiten Speichermittel aus einem R/S-Flipflop (13) bestehen, dem ein D-Flipflop (16) folgt.

## Claims

1. A logic analyzer comprising:
- a channel selector (10) with first inputs (11) for receiving a combination of digital signals, second inputs for receiving a first references combination (C) of digital signals at a given instant, and first logic gates (20₁ - 20_{N}) for detecting, in a first mode, that the first combination (C) is reproduced on its first inputs,
- a counter (12) which is controlled by a clock (CL1) enabled by the output of the selector (10), the selector output also starting the counter which receives in advance a first target value (M) which defines a first predetermined duration,
- a first storage means (15) which stores and supplies a first enable signal (S1) which is active when the first combination (C) remains reproduced beyond said first duration, the first storage means being activated by the counter (12),
characterized in that:
- the selector (10) comprises third inputs for receiving a second reference combination (B) and second logic gates (21₁ - 21_{N}) for selecting, in a second mode, a channel of the first inputs (11) on which the appearance of a series of identical bits in the combination of digital signals is detected,
- the counter (12) receives in advance a second target value (M) which defines a second predetermined duration, the counter being started by the output of said selector (10),
- second storage means (13, 16) detect whether the appearance of the series of identical bits on the selected channel is shorter than the second predetermined duration and store and supply a second enable signal (S2) in this case,
- the selector (10) selects, at the input, the first or the second mode, depending on whether the second reference combination (B) selects all channels or a single channel, respectively,
- a multiplexer (17) selects, at the output, one of the enable signals (S1, S2) by means of a trigger mode signal (SEL).

2. A logic analyzer as claimed in Claim 1, characterized in that, in order to operate on N channels, the selector (10) comprises for each channel: a so-called first logic gate which receives a channel and one of the N bits of the first reference combination (C), the output of said first logic gate being connected to the input of a so-called second logic gate which also receives one of the N bits of the second reference combination (B), the first reference combination (C) being intended to select an arbitrary binary word, the second reference combination (B) being intended to select one of the N channels or all N channels in order to form the channel control, the second logic gates assigned to each channel having their outputs connected to a logic gate performing the logic AND-function of all these output in order to supply the output signal (A) of the selector (10).

3. A logic analyzer as claimed in Claim 1 or 2, characterized in that the first storage means is formed by a flipflop (15) which stores the output of the selector (10).

4. A logic analyzer as claimed in any one of the Claims 1 to 3, characterized in that the second storage means are formed by an R/S flipflop (13) followed by a D-flipflop (16).
